# EUROPÄISCHE PATENTSCHRIFT

(11) **EP 0 549 619 B1**
(45) Veröffentlichungstag und Bekanntmachung des Hinweises auf die Patenterteilung: **28.12.1994**
(21) Anmeldenummer: 91915510.1
(22) Anmeldetag: 06.09.1991
(51) Int. Cl.: H05K 3/36, H01L 23/538

(54) **VERFAHREN ZUM HERSTELLEN EINER SCHALTUNG**
PROCESS FOR MANUFACTURING CIRCUITS
PROCEDE DE FABRICATION DE CIRCUITS

(30) Priorität: 22.09.1990 DE 4030055
(43) Veröffentlichungstag der Anmeldung: 07.07.1993
(73) Patentinhaber: ROBERT BOSCH GMBH, 70442 Stuttgart (DE)
(72) Erfinder: ZIMMERMANN, Herbert, D-7141 Freiberg/Heutingsheim (DE); STEINLE, Klaus, D-7032 Sindelfingen (DE); SPITZENBERGER, Kurt, D-7256 Merklingen (DE); STECHER, Guenther, D-7140 Ludwigsburg (DE)
(86) Internationale Anmeldenummer: DE9100709
(87) Internationale Veröffentlichungsnummer: WO9205677

(56) Entgegenhaltungen:
- DE-A- 2 736 055
- US-A- 4 130 722
- US-A- 4 652 977
- US-A- 4 799 984
- PATENT ABSTRACTS OF JAPAN, vol. 10, no. 197 (E-418)(2253) 10. Juli 1986 & JP-A-61 042 159
- PATENT ABSTRACTS OF JAPAN, vol. 10, no. 192 (E-417)(2248) 5. Juli 1986 & JP-A-61 036 962

## Beschreibung

### Stand der Technik

Die Erfindung betrifft ein Verfahren zum Herstellen einer Schaltung entsprechend dem Oberbegriff von Anspruch 1 (siehe DE-A- 2 736 055).

Steigende Anforderungen an die Komplexität künftiger Hybridschaltungen und die Forderung nach kurzen Leiterbahnlängen lassen sich nur mit mehrlagigen Schaltungen realisieren. Wegen prozeßbedingter Nachteile, insbesondere wegen geometrischer Beschränkungen durch unebene Topographie und Substratwölbung und durch fallende Ausbeuten infolge der hohen Anzahl von Prozeßschritten bei mehrlagigen Dickschichtschaltungen mit gedrucktem Dielektrikum wurden neue Verfahren entwickelt. Hierzu gehört das sogenannte Greentape-Verfahren. Bei diesem Greentape- oder Greensheet-Verfahren werden ungesinterte Keramikfolien mit Schaltelementen und Leiterbahnen bedruckt, in der Regel zu einer Multilayerschicht zusammengelegt, gepreßt und gesintert. Die Entwicklung dieser tiefsinternden (bei etwa 850°C) Glaskeramikfolien erlaubt die Realisierung von Mehrlagenschaltungen hoher Komplexität mit hoher Ausbeute.

Andererseits liegt die Wärmeleitfähigkeit dieser Mehrlagenschaltungen nur bei etwa 15% einer beispielsweise aus Al₂O₃ bestehenden Keramik. Ebenfalls liegt die mechanische Festigkeit unter derjenigen einer Al₂O₃-Keramik und zwar sogar unter der Hälfte. Diese Greentape-Schaltungen sind deshalb für eine robuste Anwendung in der Autoelektronik wenig geeignet.

Ein Keramiksubstrat soll mit einer zweiten Schaltungsebene aus einem Greentape-Substrat verbunden werden. Beispielsweise kann das Greentape-Substrat als Mehrlagenschaltungen den Signalteil einer Dickschicht-Hybridschaltung bilden. Hierzu ist allerdings eine zuverlässige elektrische und mechanische Verbindung zwischen den beiden Substraten notwendig. Diese Verbindung ist Gegenstand des weiter unten beschriebenen Verfahrensablaufes.

Die Mehrlagenschaltung wird im allgemeinen nur einen Teil der Schaltungsfläche des Keramiksubstrates überdecken. Auch könnte die Mehrlagenschaltung, d.h. das Greentape-Substrat, Aussparungen aufweisen, in die Leistungsbauelemente eingesetzt werden, welche dann mit der Schaltung elektrisch verbunden sind, beispielsweise durch Bonddrähte.

Es werden vor dem Verbinden von Keramiksubstrat und Greentape-Substrat in das Greentape-Substrat Vias eingeformt und mit Silber od. dgl. leitendem Kontaktmaterial aufgefüllt. Die Oberflächen dieses Kontaktmaterials bilden dann Gegenkontaktflächen zu Kontaktflächen auf dem Keramiksubstrat. Vias sind im übrigen gestanzte und gebohrte Löcher in dem Greentape-Substrat. Ein typischer Via-Durchmesser beträgt ca. 0,2mm.

Ferner werden vor dem Verbinden der beiden Substrate die Kontaktflächen auf dem Keramiksubstrat mit einer Verbindungsschicht bedruckt. Als Verbindungsschicht bietet sich eine glasarme bzw. glasfreie Silberpaste an. Wird als Verbindungsschicht Kupfer gewählt, läßt sich eine besonders zuverlässige Verbindung zwischen den beiden Silberkontaktflächen erzielen.

Der Durchmesser der Kontaktflächen und damit auch der Verbindungsschicht soll in jedem Fall größer sein, beispielsweise 1mm, als der Durchmesser der Gegenkontaktflächen (0,2mm). Hierdurch besteht eine gewisse Toleranz beim Aufsetzen des Greentape-Substrates auf das Keramiksubstrat, wenn die Gegenkontaktfläche auf die Kontaktfläche trifft.

Gemäß dem kennzeichnenden Teil des Anspruchs 1 oder 8 der vorliegenden Erfindung wird vor dem Verbinden von Keramiksubstrat und Greentape-Substrat entweder das Keramiksubstrat oder das Greentape-Substrat oder beide auf den miteinander zu verbindenden Flächen mit Stegen aus einem Glas bedruckt werden. Als günstig haben sich hier kreuzförmige Glasstege erwiesen. Bei dem Glas handelt es sich um ein etwa bei 500°C aufschmelzendes Glas. Die typischen Abmessungen der Stege sind 5mm Länge und 0,5mm Breite.

Die getrocknete Dicke der bevorzugt kreuzförmigen Glasstege kann dabei die Summe der Dicke von Kontaktfläche und Verbindungsschicht von ca. 40µm deutlich übersteigen.

Die so vorbereiteten Substrate werden nun aufeinandergelegt, so daß sich möglichst Kontaktflächen und Gegenkontaktlächen gegenüberliegen. Danach erfolgt ein Brennen der Gesamtschaltung, welches in einem Durchlaufofen bei ca. 850°C bzw. ca. 770° C vorgenommen wird.

Beim Brennen versintern die Kontaktflächen und die Gegenkontaktflächen durch die aufgebrachte Verbindungsschicht und bilden dabei Podeste von um die 15µm Höhe aus. Da Silber und Kupfer bei 780° C ein eutektisches Gefüge bilden, läßt sich eine besonders zuverlässige Verbindung erreichen, wenn die Anordnung bei ca. 10° C unterhalb dieser Temperatur gebrannt wird. Das bei der Brenntemperatur von ca. 850°C bzw. 770° C niederviskose Glas der Stege verbindet in dem sich ausbildenden Spalt von ca. 15µm Breite beide Substrate. Dabei fließt das Glas etwa um das Doppelte auseinander, so daß der Abstand der beiden Substrate vermindert und dabei das sichere Verbinden von Kontaktflächen und Gegenkontaktflächen gewährleistet wird.

Der hohe Glasanteil des Greentape-Substrates von ca. 40GW% führt bei der Brenntemperatur von 850°C zum Erweichen des Greentape-Substrates und gewährleistet damit das Zusammensintern aller Kontaktstellen auch bei ungeschliffenem Keramiksubstrat. Der Unterschied zwischen Brenntemperatur (ca. 850°C) und Schmelztemperatur des Glases (ca. 500°C), welches zur mechanischen Verbindung verwendet wird, entschärft die kritischen, in der Praxis sonst nicht beherrschbaren Schichtdickenrelationen zwischen Kontaktierungspunkten und Glasstegen.

Ein weiterer Vorteil der vorliegenden Erfindung liegt darin, daß die angewendeten Prozesse weitgehend denjenigen entsprechen, die bereits für die Mengenfertigung von Dickschichtschaltungen eingesetzt werden. Ferner werden die Vorteile der Dickschichtschaltungen auf Keramik mit denjenigen der Greentape-Schaltungen verbunden. Eine hohe mechanische Festigkeit und eine gute Wärmeleitfähigkeit bleibt gewährleistet.

Die Erfindung umfaßt auch eine Schaltung, die entsprechend dem oben genannten Verfahren hergestellt wurde.

### Zeichnung

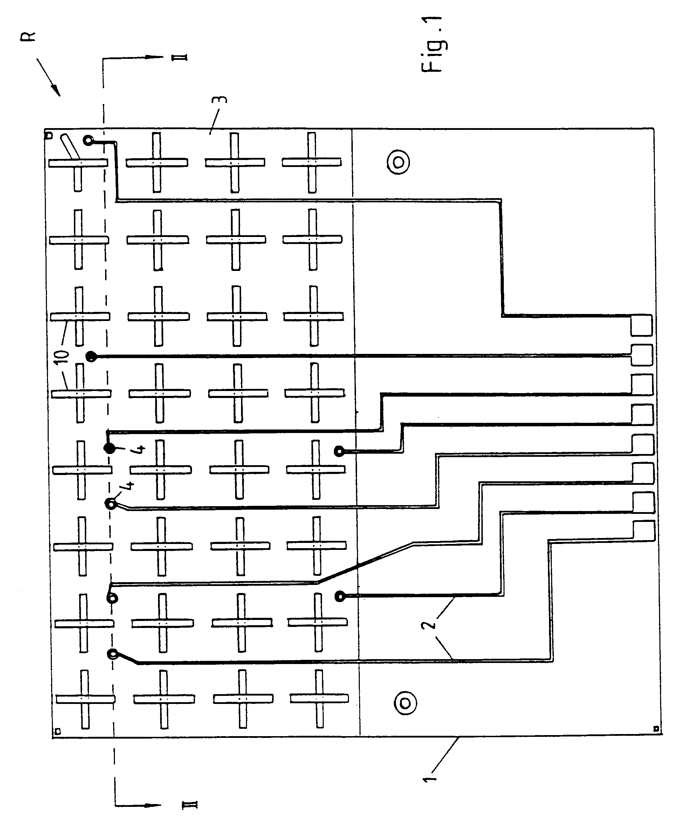

Weitere Vorteile der Erfindung werden anhand der Zeichnung näher erläutert; diese zeigt in
- Figur 1: eine Draufsicht auf eine erfindungsgemäße Gesamtschaltung;
- Figur 2: einen teilweise vergrößert dargestellten Querscnnitt durch die Gesamtschaltung entlang Linie II-II in Figur 1.

Eine erfindungsgemäße Gesamtschaltung R weist ein Keramiksubstrat 1, welches mit Leiterbahnen 2 belegt ist. Dieses Keramiksubstrat 1 bildet eine erste Schaltungsebene. Über dem Keramiksubstrat 1 ist dieses teilweise überdeckend eine zweite Schaltungsebene angeordnet, welche als Greentape-Substrat 3 ausgebildet ist. Dieses Greentape-Substrat 3 besteht aus übereinandergelegten Keramikfolien, wobei durch Stapeln mehrerer mit Leiterbahnen bedruckter Folien eine Mehrlagenschaltung entsteht. Diese Mehrlagenschaltung kann beispielsweise den Signalteil für die erste Schaltungsebene bilden, wobei diese erste Schaltungsebene eine Dickschicht-Schaltung sein kann.

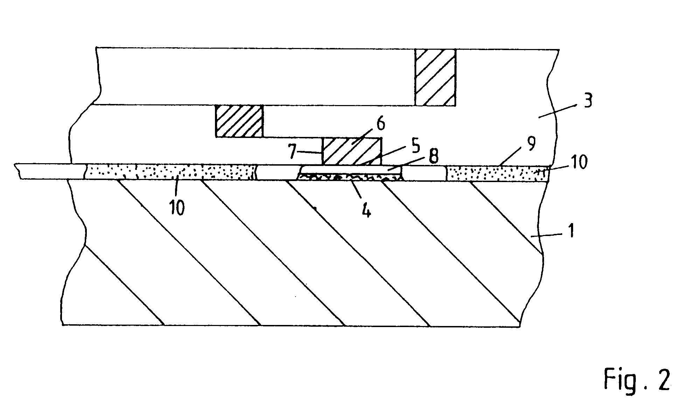

Auf das Keramiksubstrat 1 sind am Ende der Leiterbahnen 2 Kontaktflächen 4 vorgesehen. Der Durchmesser der Kontaktflächen 4 kann beispielsweise bis zu 1mm betragen. In jedem Fall ist er größer als eine Gegenkontaktfläche 5 (siehe Figur 2) in der zweiten Schaltungsebene 3, welche aus einer Silberfüllung 6 im Via 7 besteht. Diese Vias 7 sind in das die zweite Schaltungsebene bildende Greentape-Substrat 3 eingestanzte oder gebohrte Löcher, die danach mit dem Silber 6 aufgefüllt werden.

Auf die Kontaktflächen 4 wird dann eine Verbindungsschicht 8 aufgedruckt, wobei diese aus einer glasarmen bzw. glasfreien Silberpaste bestehen kann. Als sehr günstig hat sich aus den genannten Gründen auch eine Kupfer-Paste erwiesen.

Nunmehr wird das Keramiksubstrat 1 oder die Unterseite 9 des Greentape-Substrates 3 oder beide mit kreuzförmigen Stegen 10 eines um 500°C aufschmelzenden Glases bedruckt. Typische Abmessungen dieser Stege sind 5mm Länge und 0,5mm Breite. Die Dicke der nach dem Bedrucken getrockneten Stege 10 kann die Summe der Dicken von Kontaktfläche 4 plus Verbindungsschicht 8 von ca. 40µm deutlich übersteigen.

Nach dem Trocknen der Stege 10 und insbesondere der Verbindungsschicht 8 wird das Greentape-Substrat 3 auf das Keramiksubstrat 1 gelegt, so daß die Gegenkontaktfläche 5 über der ihr zugeordneten Verbindungsschicht 8 bzw. Kontaktfläche 4 zu liegen kommt.

Nunmehr erfolgt ein Brennen der übereinanderliegenden Substrate 1 und 3 beispielsweise in einem Durchlaufofen bei etwa 850°C bzw. etwa 770° C für Kupfer als Verbindungsschicht. Beim Brennen versintern die Kontaktflächen 4 und die Gegenkontaktflächen 5 durch die aufgebrachte Verbindungsschicht 8 und bilden dabei Podeste von etwa 15µm Höhe aus. Bei einer Fügetemperatur von ca. 850°C bzw. ca. 770° C fließen auch die Stege 10 aus niederviskosem Glas auseinander und verbreitern sich etwa um das Doppelte. Hierdurch wird der erforderliche Kontakt zwischen Gegenkontaktfläche 5 und Verbindungsschicht 8 hergestellt und auch eine Verbindung der beiden Substrate 1 und 3 bewirkt. Da der Durchmesser der Kontaktflächen 4 wesentlich größer ist als der Durchmesser der Gegenkontaktflächen 5, können teilweise auftretende Verschiebungen beim Aufsetzen des Greentape- Substrates 3 auf das Keramiksubstrat 1 ausgeglichen werden.

## Patentansprüche

1. Verfahren zum Herstellen einer Schaltung mit einer ersten Schaltungsebene aus einem Keramiksubstrat (1), welches mit beispielsweise Dickschicht-Strukturen belegt, mit entsprechenden Leiterbahnen (2) mit Kontaktflächen (4) bedruckt und mit einer zweiten Schaltungsebene aus einem Greentape-Substrat (3) verbunden wird, dadurch gekennzeichnet, daß das Keramiksubstrat (1) und/oder eine Unterseite des Greentape-Substrates (3) mit Stegen (10) aus einem Glas bedruckt wird/werden und daß das Brennen bei einer Temperatur erfolgt, welche der Fügetemperatur der Kontaktflächen (4, 5, 6, 8) entspricht und höher ist als die Schmelztemperatur der Glasstege (1).

2. Verfahren nach Anspruch 1, dadurch gekennzeichnet, daß in das Greentape-Substrat (3) Vias (7) eingeformt und mit Silber (6) oder dergleichen leitendem Kontaktmaterial aufgefüllt werden, welche Gegenkontaktflächen (5) zu den Kontaktflächen (4) auf dem Keramiksubstrat (1) ausbilden.

3. Verfahren nach Anspruch 1 oder 2, dadurch gekennzeichnet, daß die Kontaktflächen (4) auf dem Keramiksubstrat (1) einen größeren Durchmesser aufweisen als die Gegenkontaktflächen (5) in dem Greentape-Substrat (3).

4. Verfahren nach einem der vorhergehenden Ansprüche, dadurch gekennzeichnet, daß die Kontaktflächen (4) mit einer Verbindungsschicht (8) bedruckt werden.

5. Verfahren nach Anspruch 4, dadurch gekennzeichnet, daß die Kontaktflächen (4) mit einer glasarmen bzw. glasfreien Silber-Paste bedruckt werden.

6. Verfahren nach Anspruch 4, dadurch gekennzeichnet, daß die Kontaktflächen (4) mit einer Kupfer-Paste bedruckt werden.

7. Verfahren nach einem der vorhergehenden Ansprüche, dadurch gekennzeichnet, daß Keramiksubstrat (1) und Greentape-Substrat (3) so aufeinandergelegt werden, daß sich Kontaktflächen (4) mit Verbindungsschichten (8) und Gegenkontaktflächen (5) gegenüberliegen und anschließend gebrannt werden.

8. Schaltung mit einer ersten Schaltungsebene aus einem Keramiksubstrat (1), welches mit beispielsweise Dickschicht-Hybriden belegt und mit entsprechenden Leiterbahnen (2) mit Kontaktflächen (4) bedruckt ist, wobei über dem Keramiksubstrat (1) ein Greentape-Substrat (3) angeordnet ist, dadurch gekennzeichnet, daß das Greentape-Substrat (3) mit dem Keramiksubstrat (1) über geschmolzene Glasstege (10) durch Brennen verbunden ist.

9. Schaltung nach Anspruch 8, dadurch gekennzeichnet, daß die Kontaktflächen (4) über eine Verbindungsschicht (8) mit Gegenkontaktflächen (5) in dem Greentape-Substrat (3) durch Sintern bzw. Bildung einer eutektischen Kupfer-Silber-Verbindung verbunden sind.

10. Schaltung nach Anspruch 8 oder 9, dadurch gekennzeichnet, daß die Verbindungsschicht (8) aus einer glasarmen bzw. glasfreien Silber-Paste, einer Kupfer-Paste oder dergleichen besteht.

11. Schaltung nach einem der Ansprüche 9 oder 10, dadurch gekennzeichnet, daß die Gegenkontaktflächen (5) von Silber (6) gebildet sind, welches in Vias (7) in dem Greentape-Substrat (3) eingefüllt ist.

12. Schaltung nach einem der Ansprüche 9 bis 11, dadurch gekennzeichnet, daß der Durchmesser der Gegenkontaktflächen (5) kleiner ist als der Durchmesser der Kontaktflächen (4).

13. Schaltung nach einem der Ansprüche 8 bis 12, dadurch gekennzeichnet, daß die Glasstege (10) aus einem Glas bestehen, welches bei ca. 500° C schmilzt.

14. Schaltung nach einem der Ansprüche 8 bis 13, dadurch gekennzeichnet, daß die Brenntemperatur bei ca. 850° C für eine Silber-Paste, bzw. bei ca. 770° C für eine Kupfer-Paste liegt.

## Claims

1. Method of producing a circuit having a first circuit level comprising a ceramic substrate (1) which is covered with, for example, thick-film structures, is printed with suitable conductor tracks (2) having contact areas (4) and is connected to a second circuit level comprising a green-tape substrate (3), characterized in that the ceramic substrate (1) and/or an underside of the green-tape substrate (3) is/are printed with ridges (10) composed of a glass and in that the firing is carried out at a temperature which is equal to the joining temperature of the contact areas (4, 5, 6, 8) and is higher than the melting point of the glass ridges (10).

2. Method according to Claim 1, characterized in that vias (7) are formed in the green-tape substrate and are filled with silver (6) or a similar conducting contact material, which vias form countercontact areas (5) to the contact areas (4) on the ceramic substrate (1).

3. Method according to Claim 1 or 2, characterized in that the contact areas (4) on the ceramic substrate (1) have a larger diameter than the countercontact areas (5) in the green-tape substrate (3).

4. Method according to one of the preceding claims, characterized in that the contact areas (4) are printed with a connecting layer (8).

5. Method according to Claim 4, characterized in that the contact areas (4) are printed with a low-glass or glass-free silver paste.

6. Method according to Claim 4, characterized in that the contact areas (4) are printed with a copper paste.

7. Method according to one of the preceding claims, characterized in that the ceramic substrate (1) and the green-tape substrate (3) are laid on top of one another in such a way that the contact areas (4) with connecting layers (8) and countercontact areas (5) are situated opposite and are subsequently fired.

8. Circuit having a first circuit level comprising a ceramic substrate (1) which is covered with, for example, thick-film hybrids and is printed with suitable conductor tracks (2) having contact areas (4), a green-tape substrate (3) being disposed above the ceramic substrate (1), characterized in that the green-tape substrate (3) is joined to the ceramic substrate (1) by means of fused glass ribs (10) as a result of firing.

9. Circuit according to Claim 8, characterized in that the contact areas (4) are joined via a connecting layer (8) to countercontact areas (5) in the green-tape substrate (3) by sintering or by the formation of a eutectic copper/silver compound.

10. Circuit according to Claim 8 or 9, characterized in that the connecting layer (8) is composed of a low-glass or glass-free silver paste, a copper paste or the like.

11. Circuit according to one of Claims 9 or 10, characterized in that the countercontact areas (5) are formed by silver (6) which has been introduced into the vias (7) in the green-tape substrate (3).

12. Circuit according to one of Claims 9 to 11, characterized in that the diameter of the countercontact areas (5) is less than the diameter of the contact areas (4).

13. Circuit according to one of Claims 8 to 12, characterized in that the glass ridges (10) are composed of a glass which melts at approximately 500°C.

14. Circuit according to one of Claims 8 to 13, characterized in that the firing temperature is approximately 850°C for a silver paste or approximately 770°C for a copper paste.

## Revendications

1. Procédé de fabrication d'un circuit avec un premier plan de circuits formé d'un substrat en matière céramique (1) occupé par exemple par des structures en couche épaisse, avec en impression des chemins conducteurs (2) et des surfaces de contact (4) ainsi qu'un second plan de circuits formé d'un substrat « Greentape » (3), procédé caractérisé en ce qu'on imprime sur le substrat en matière céramique (1) et/ou sur la face inférieure du substrat « Greentape » (3), des barrettes (10) en verre et on cuit à une température qui correspond à la température de la structure des surfaces de contact (4, 5, 6, 8) et est supérieure à la température de fusion des barrettes en verre (1).

2. Procédé selon la revendication 1, caractérisé en ce qu'on forme des chemins (7) dans le substrat « Greentape » (3) et on les remplit avec de l'argent (6) ou un matériau de contact de même conductivité, formant les contre-surfaces de contact (5) pour les surfaces de contact (4) du substrat en matière céramique (1).

3. Procédé selon la revendication 1 ou 2, caractérisé en ce que les surfaces de contact (4) sur le substrat en céramique (1) ont un diamètre plus grand que les contre-surfaces de contact (5) du substrat « Greentape » (3).

4. Procédé selon l'une des revendications précédentes, caractérisé en ce qu'on imprime sur les surfaces de contact (4) une couche de liaison (8).

5. Procédé selon la revendication 4, caractérisé en ce qu'on imprime sur les surfaces de contact (4) une pâte d'argent sans verre ou à faible teneur en verre.

6. Procédé selon la revendication 4, caractérisé en ce qu'on imprime une pâte de cuivre sur les surfaces de contact (4).

7. Procédé selon l'une des revendications précédentes, caractérisé en ce qu'on superpose le substrat en céramique (1) et le substrat « Greentape » (3) pour que les surfaces de contact (4) avec les couches de liaison (8) et les contre-surfaces de contact (5) soient en regard puis on cuit.

8. Circuit comportant un premier plan de circuits formé d'un substrat en matière céramique (1) occupé par exemple par des circuits hybrides en couche épaisse et ayant des chemins conducteurs (2) correspondant à des surfaces de contact (4), un substrat « Greentape » (3) étant prévu sur le substrat en céramique (1), circuit caractérisé en ce que le substrat « Greentape » (3) est relié par cuisson au substrat en matière céramique (1) par des barrettes de verre fondu (10).

9. Circuit selon la revendication 8, caractérisé en ce que les surfaces de contact (4) sont reliées par une couche de liaison (8) aux contre-surfaces de contact (5) dans le substrat « Greentape » (3) par frittage et en formant une liaison eutectique cuivre-argent.

10. Circuit selon la revendication 8 ou 9, caractérisé en ce que la couche de liaison (8) est une pâte d'argent sans verre ou à faible teneur en verre, une pâte de cuivre ou pâte analogue.

11. Circuit selon l'une des revendications 9 ou 10, caractérisé en ce que les contre-surfaces de contact (5) sont en argent (6) introduit dans le substrat « Greentape » (3) par des chemins (7).

12. Circuit selon l'une des revendications 9 à 11, caractérisé en ce que le diamètre des contre-surfaces de contact (5) est inférieur au diamètre des surfaces de contact (4).

13. Circuit selon l'une des revendications 8 à 12, caractérisé en ce que les barrettes de verre (10) sont en un verre dont le point de fusion est voisin de 500°C.

14. Circuit selon l'une des revendications 8 à 13, caractérisé en ce que la température de combustion se situe à environ 850°C pour une pâte en argent et à environ 770°C pour une pâte en cuivre.
